# EUROPEAN PATENT APPLICATION

(11) **EP 1 645 664 A1**
(43) Date of publication of application: **12.04.2006**
(21) Application number: 04748916.6
(22) Date of filing: 27.05.2004
(51) Int. Cl.: C30B 33/04, C30B 33/02, C30B 29/04, C01B 31/06

(54) **THE TECHNIQUE OF PRODUCTION OF FANCY RED DIAMONDS**

(30) Priority: 26.06.2003 RU 2003119470
(71) Applicant: Vins, Viktor Genrihovich, Novosibirsk, 930090 (RU)
(72) Inventor: Vins, Viktor Genrihovich, Novosibirsk, 930090 (RU)
(74) Representative: Jeck, Anton
(86) International application number: PCT/RU2004/000205
(87) International publication number: WO 2004/113597

(57) **Zusammenfassung**

Die Erfindung gehört zum Bereich der Diamantenbearbeitung (Diamantenveredelung), die das Anfärben mit verschiedenen Farben betrifft. Die Erfindung kann in der Schmuckwarenindustrie Anwendung finden. Das Verfahren besteht darin, dass im Kristallgitter eines Naturdiamanten vom Typ la, der Verarmungstypen enthält, oder im Kristallgitter eines Naturdiamanten vom Typ la mit hohem Stickstoffgehalt, der mehr als 800 ppm Stickstoffbeimischung vom Verarmungstyp A oder B1 enthält, isolierte Stickstoffatome in der Substitutionsposition gebildet werden, und zwar vom Verarmungstyp C. Der den Verarmungstyp A enthaltende Naturdiamant vom Typ la wird in einem Hochdruckgerät bei einer Temperatur von mehr als 2150° C bei einem stabilisierten Druck von 6,0-7,0 Gpa ausgeglüht, dann wird er durch einen Elektronenstrom von 5x10¹⁵-5x10¹⁸cm⁻² bei 2-4 MEV bestrahlt und dem Aushärten im Vakuum bei einer Temperatur von mindestens 1100° C unterzogen. Der Naturdiamant vom Typ la mit hohem Stickstoffgehalt, der mehr als 800 ppm Stickstoffbeimischung vom Verarmungstyp A oder B1 enthält, wird durch einen hochenergetischen Elektronenstrom mit einer Bestrahlungsdosis von mehr als 10¹⁹cm⁻² bestrahlt und dem Aushärten im Vakuum bei einer Temperatur von mindestens 1100° C unterzogen. Es ergeben sich Diamanten mit einer Phantasierotfarbe, die für Brillanten mit festen N-V-Färbungszentren bestimmt sind, die im Wellenlängenbereich von 400-640 nm absorbieren.

## Description

Die Erfindung gehört zum Bereich der Diamantenbearbeitung (Diamantenveredelung), nämlich zum Anfärben mit verschiedenen Farben, insbesondere zum Anfärben von Naturdiamanten mit einer einzigartigen Phantasierotfarbe. Die Erfindung kann in der Juwelierwarenindustrie Anwendung finden.

Durch die RU 2145365 C1, 10.02.2000, ist ein Verfahren zur Gewinnung von Diamanten mit rotgelben und schwarzen Schattierungen bekannt, das auf dem Prinzip der Farbenüberlagerung beruht, dass heißt, der Gewinnung einer gewünschten Farbe durch Mischung einer Naturfarbe mit einer "aufgetragenen" Farbe durch Elektronenstrom in der Zeitspanne von 5x10¹⁵-5x10¹⁸cm⁻² und durch Aushärten bei einer Temperatur von 300-1900° C während eines Zeitraums von 30 Minuten bis einigen Stunden bei Normalluftdruck sowie unter Ultravakuum und mit Impulserhitzung. Der Vorgang wird mehrmals wiederholt, bis die nötige Farbart erreicht wird.

Die moderne, allgemein übliche, physikalische Klasseneinteilung von Diamanten ist in der Fachliteratur beschrieben (z.B. Walker, John, Optical absorption and luminescence in diamond, in "Reports on Progress Physics", 1979, Band Nr. 42). Dort sind Diamanten in vier Typen eingeteilt:
- Klasse IIa: Diamanten mit geringem Stickstoffgehalt. Grundkriterien der Klasseneinteilung: Fehlen der Absorbierung von Licht im Infrarotspektrum, scharf ausgeprägte Kante der fundamentalen Absorbierung im ultravioletten Spektrum bei 225 nm. Die Diamanten dieses Typs sind ganz schwer zu finden; deren Anzahl beträgt nicht mehr als 2 % der gesamten Anzahl der Naturdiamanten;
- Klasse IIb: blaue Halbleiterdiamanten. Sie enthalten noch weniger Stickstoff als Diamanten der Klasse IIa. Die blaue Färbung und Halbleitereigenschaften sind durch Beimischung von Bor bedingt. Die Beimischform von Bor ist ein isoliertes Atom in Substitutionsposition.

Der am häufigsten anzutreffende Typ ist der Naturdiamant (bis 98 %), der bis 0,3 Atomprozent Stickstoff enthält. Am häufigsten sind der Verarmungstyp A als Beimischformen des Störstickstoffs anzutreffen, wobei der Verarmungstyp A ein enges Stickstoffpaar in nebeneinander liegenden Kristallgitterplätzen darstellt, sowie der Verarmungstyp B1, die vier Stickstoffatome um eine Leerstelle aufweist.

Die am seltensten (weniger als 0,2 %) in der Natur anzutreffenden Diamanten sind Komponenten der meisten synthetischen Diamanten (Kunstdiamanten). Sie enthalten isolierte Stickstoffatome (Verarmungstyp C) als Substitutionsstörstelle von bis 0,05 Atomprozent (etwa 5-6 ppm). Der mit dem Verarmungstyp C verbundene Absorptionsstreifen beginnt im sichtbaren Bereich bei etwa 500 nm und verstärkt sich in Richtung von kurzen Wellenlängen, wodurch die gelbe Färbung der Diamanten des Typs IIb bedingt ist.

Es ist bekannt, dass, um den Diamanten verschiedene Farbschattierungen der Rotfarbe zu verleihen, zwischen der ganzen Vielfalt von Naturdiamanten mit Hilfe der Verfahren der optischen Spektroskopie Kristalle ausgesondert werden, die einen Teil des Störstickstoffs als isolierte Substitutionsatome (Verarmungstyp C) enthalten. Gemäß der physikalischen Klasseneinteilung von Diamanten können solche Diamanten entweder dem Typ Ib oder den gemischten Typen Ia+Ib oder Ib+Ia zugeschrieben werden. Im Buch von Collins, A.T., Migration of nitrogen in electron irradiated typed Ib diamond, "J. Phys. C: Solid State Phys.", 1978, Band 11, 10, L417-L422, sind fundamentale Prozesse der Verarmungstypumformung im Kristallgitter des Diamanten des Typs Ib bei Bestrahlung mit hochenergetischem Elektronenstrom (10²²m⁻²/2 MB) und bei weiterer Aushärtung im Vakuum (800° C, 2 Stunden) beschrieben. Im Laufe der Bestrahlung tritt eine große Anzahl von primären Strahlenschäden auf, und zwar Leerstellen und Zwischengitterstellen. Das nachfolgende Hochtemperatur-Aushärten im Vakuum sichert die Gewinnung von standfesten N-V-Färbungszentren, die isolierte Stickstoffatome in der Substitutionsposition mit Leerstellen in nebeneinander liegenden Kristallgitterplätzen darstellen. Solche Verarmungstypen haben eine Absorbierung im roten Spektrum bei Wellenlängen von mindestens 640 nm (1,945 EV), und sie bedingen die rote Färbung von Diamantenkristallen mit verschiedener Intensität.

Durch die US 4 950 463 A, 21.08.1990, ist ein Verfahren zur Gewinnung von Purpurdiamanten mit Hilfe eines Kunstdiamanten bekannt. Gemäß diesem Verfahren wird der Kunstdiamant des Typs Ib mit Stickstoffgehalt als Verarmungstyp C im Bereich von 8x10¹⁷-1,4x10¹⁹ Atomen/cm³ (oder von 4,5-80 ppm) durch einen Elektronenstrom im Bereich von 5x1016-2x1018 cm⁻² bei 2-4 MB mit nachfolgendem Aushärten im Vakuum von mindestens 10⁻² Torr bei einer Temperatur von 800-1100° C während mehr als 20 Stunden bestrahlt. Es werden Kristalle von Purpurdiamanten mit N-V-Färbungszentren gewonnen, die eine Absorbierung im Bereich von 500-640 nm bei einer Spitze von 570 nm aufweisen.

Wie es aufgrund der Analyse von Anregungsspektren der Lumineszenzstrahlung im Artikel von Winss, W. G., Spektroskopie von optisch aktiven Verarmungstypen im Kunstdiamant, Autoreferat der Dissertation im Bereich physikalisch-mathematischer Wissenschaften, Minsk, 1989, 21 S., festgestellt wurde, absorbieren N-V-Zentren allerdings im Bereich von 400-640 nm, und diese Absorbierung in Diamanten des Typs Ib trifft mit der Absorbierung von Verarmungstypen C zusammen. Die Absorbierung beginnt und steigt bei Wellenlängen von mindestens 500 nm. Schließlich liegt das Gesamtspektrum der Absorbierung von Diamanten des Typs Ib mit N-V-Zentren im Wellenlängenbereich von 400-640 nm.

Die Aufgabe der Erfindung besteht in der Entwicklung eines solchen Gewinnungsverfahrens von Diamanten mit einer Phantasierotfarbe, das es ermöglicht, im Kristallgitter eines Naturdiamanten des Typs la standfeste N-V-Färbungszentren zu gewinnen, die im roten Spektrum bei Wellenlängen von 400-640 nm absorbieren.

Dafür werden Kristalle von Naturdiamanten des Typs la verwendet, und im Kristallgitter dieser Naturdiamanten werden isolierte Stickstoffatome in der Substitutionsposition vom Verarmungstyp C gebildet; dann werden die Naturdiamanten mit einem hochenergetischen Elektronenstrom bestrahlt und einer Hochtemperatur-Aushärtung im Vakuum unterzogen. Dabei enthält der Naturdiamant des Typs la eine Stickstoffbeimischung vom Verarmungstyp C, oder er wird mit einem hohen Stickstoffgehalt versehen und enthält eine Stickstoffbeimischung vom Verarmungstyp A und B1 mit einer Konzentration von mehr als 800 ppm.

Der Naturdiamant des Typs la, der eine Stickstoffbeimischung vom Verarmungstyp A enthält, wird vorher einer Hochtemperatur-Aushärtung in einem Hochdruckgerät bei einer Temperatur von mehr als 2150° C und bei einem stabilisierenden Druck von 6,0-7,0 Gpa (die so genannte NRNT-Bearbeitung) unterzogen; dann wird er durch einen hochenergetischen Elektronenstrom von 5x10¹⁵-5x10¹⁸cm⁻² bestrahlt, vorzugsweise von 10¹⁸cm⁻²; dann wird er bei 2-4 MV dem Hochtemperatur-Aushärten im Vakuum bei einer Temperatur von mindestens 1100° C unterzogen.

Der Naturdiamant mit hohem Stickstoffgehalt des Typs la, der eine Stickstoffbeimischung vom Verarmungstyp A und B1 mit einer Konzentration von mehr als 800 ppm enthält, wird mit einem hochenergetischen Teilchenstrom, beispielsweise mit Elektronen, und mit einer Bestrahlungsdosis von mehr als 10¹⁹cm⁻² bearbeitet und wird dem Hochtemperatur-Aushärten im Vakuum bei einer Temperatur von mindestens 1100° C unterzogen.

Versuchsergebnisse der Erfinder weisen darauf hin, dass bei der NRNT-Bearbeitung des Naturdiamanten vom Typs la, der eine Stickstoffbeimischung vom Verarmungstyp A enthält (Stickstoffpaar in nebeneinander liegenden Kristallgitterplätzen), bei einer Temperatur von mehr als 2150° C eine Dissoziation von etwa 15-20 % des Verarmungstyps A mit einer Herausbildung des Verarmungstyps C neben anderen Verarmungstypen mit einer Konzentration von mindestens 10 ppm auftritt. Wie die vorher im Werk von Winss, W. G., Farbenveränderung von brauen Naturdiamanten unter Hochdruck- und Hochtemperaturwirkung, Aufzeichnungen von Wserossijskoe Minerologitscheskoe Obschestwo (Aufzeichnungen von der Russischen Mineralogischen Gesellschaft), 2002, 4, S. 112-119, zitierten Forschungen gezeigt haben, erfolgt bei niedrigeren Temperaturen der NRNT-Bearbeitung (von weniger als 2150° C) keine Dissoziation von Verarmungstypen A und entsprechend keine Herausbildung von Verarmungstypen C. Die Verarmungstypen C, die sich bei Temperaturen der NRNT-Bearbeitung von mehr als 2150° C herausbilden, reichen dafür aus, dass sich standfeste N-V-Färbungszentren im Laufe der nach der NRNT-Bearbeitung folgenden Bestrahlung durch den Elektronenstrom und des Hochtemperatur-Aushärtens von Diamanten im Vakuum herausbilden, die eine Absorbierung im roten Spektrum bei Wellenlängen von 400-640 nm aufweisen und die dem Diamanten verschiedene Schattierungen der Phantasierotfarbe sichern.

Der Herausbildungsmechanismus von Verarmungstypen C im Kristallgitter des Diamanten bei der Bestrahlung eines Originaldiamanten mit hohem Stickstoffgehalt des Typs la, der eine Stickstoffbeimischung vom Verarmungstyp A enthält (Stickstoffpaar in nebeneinander liegenden Kristallgitterplätzen) oder vom Verarmungstyp B (vier Stickstoffatome um eine Leerstelle herum) mit einer Konzentration von mehr als 800 ppm mit großen Dosen von hochenergetischen Teilchen, beispielsweise mit Elektronen, steht mit einer Verschiebung von den zu den Verarmungstypen A und B 1 gehörenden Stickstoffatomen in der Zwischengitterposition im Zusammenhang. Im Laufe des nach der Bestrahlung folgenden Hochtemperatur-Aushärtens vernichten die sich in Zwischengittern befindenden Stickstoffatome Leerstellen, wobei sie isolierte Stickstoffatome in der Substitutionsposition, und zwar vom Verarmungstyp C, bilden. Außerdem wurde die Absorbierung in einem schmalen Streifen von 1346 cm⁻¹ verfolgt, die durch den Verarmungstyp C bedingt ist. Das heißt, dass auch isolierte Stickstoffatome in der Substitutionsposition (Verarmungstyp C) im Kristallgitter des Diamanten neben den sich in den Zwischengittern befindenden Stickstoffatomen erscheinen.

Die Konzentration des Verarmungstyps C beträgt dabei etwa 5 ppm. Dann ergreifen die auf diese Weise herausgebildeten Verarmungstypen C die Leerstellen, wobei sie standfeste N-V-Färbungszentren bilden, die eine Absorbierung im roten Spektrum bei Wellenlängen von nicht mehr als 640 nm aufweisen und die dem Diamanten verschiedene Schattierungen der Phantasierotfarbe sichern.

Alle Veränderungen in der Zusammensetzung und in der Konzentration von optisch aktiven Verarmungstypen (A, B1, C, N3, H3 und N-V- Färbungszentren) im Kristallgitter des Diamanten wurden aufgrund der Intensität von entsprechenden Absorbierungsstreifen im ultraroten, sichtbaren und ultravioletten Spektrum festgestellt.

Beispiele für Verfahren zur Gewinnung von Diamanten mit einer Phantasierotfarbe.

### Beispiel 1:

Kristalle eines Originaldiamanten wurden verwendet, dessen Masse 1,84 Karat beträgt, der ursprünglich eine Stickstoffbeimischung vom Verarmungstyp A mit einer Konzentration von 92 ppm und vom Verarmungstyp B1 mit einer Konzentration von 258 ppm enthält. In den Spektren der infraroten Absorbierung wurden auch Streifen von 1370 cm⁻¹ und 1430 cm⁻¹, die durch "Pleitelitzih" bedingt sind, und ein schmaler Streifen von 3107 cm⁻¹, der durch einen Störwasserstoffverarmungstyp bedingt ist, verfolgt.

Im sichtbaren Spektrum bei Wellenlängen von weniger als 650 nm wurde das monotone Anwachsen der Absorbierung in Richtung von kurzen Wellenlängen verfolgt. Es waren schwache Absorbierungssysteme von 415 nm und 503 nm zu beobachten, die durch die Verarmungstypen N3 und H3 bedingt sind. Hinsichtlich der Absorbierungsspektren und der Zusammensetzung von Beimischungsverarmungs-typen (Störverarmungstypen) entsprach der Kristall eindeutig den Diamanten des Typs la. Der Diamant wurde der NRNT-Bearbeitung in einem Hochdruckgerät bei einer Temperatur von 2150° C und bei einem Druck von 7 Gpa während 10 Minuten unterzogen. Im Laufe der NRNT-Bearbeitung hat sich die Konzentration des Verarmungstyps A auf 71 ppm vermindert; die Konzentration des Verarmungstyps B1 ist auf dem vorherigen Niveau geblieben, und es hat sich ein Verarmungstyp C mit etwa 20 ppm herausgebildet.

Die mit "Pleitelitzih" verbundene Absorbierungsintensität hat auf ein Drittel abgenommen. Es war keine mit Störwasserstoff verbundene Absorbierung zu sehen. Im sichtbaren Spektrum war ein Absorbierungsanstieg bei Wellenlängen von weniger als 550 nm zu erkennen. Die Durchlasskante war bei 423 nm. In den Spektren gab es Systeme von 503 nm mit sehr schwacher Intensität und von 990 nm im am nächsten liegenden, infraroten Bereich. Nach der NRNT-Bearbeitung ist die Kristallfarbe grüngelb geworden. Nach der Zusammensetzung von Störverarmungstypen konnte der Kristall bereits als Diamant des gemischten Typs Ia+Ib bestimmt werden. Dann wurde der Kristall mit Elektronen mit einer Energiestärke von 3,0 MV und mit einer Dosis von 10¹⁸cm⁻² bestrahlt. Die Bestrahlung mit diesen Bestimmungsgrößen schafft im Kristallgitter des Diamanten etwa 10 ppm Leerstellen, die mit den aufgrund von Kunstdiamanten erhaltenen Ergebnissen übereinstimmen, die im Werk von W. G. Winss angeführt sind (Farbenveränderung von Kunstdiamanten infolge der Bestrahlung mit schnellen Elektronen und des nachfolgenden Aushärtens, Gemmologieblatt, 2002, 2(5), S. 19-33). Die Kristallfarbe nach der Bestrahlung war undurchsichtig und dunkelgrün. Dann wurde der Diamant in eine evakuierte Quarzampulle gelegt, in der er während 24 Stunden bei einer Temperatur von 1100° C ausgeglüht wurde. Im Laufe der Aushärtung durch Leerstellenmigration und der Besetzung der Leerstellen durch isolierte Stickstoffatome haben sich im Kristall 1,5-2,0 ppm N-V-Färbungszentren herausgebildet. Die Absorbierung von N-V-Färbungszentren, die bei Wellenlängen von weniger als 640 nm mit einem Spitzenwert bei 570 nm verfolgt wurde, wurde zur ursprünglichen Absorbierung mit einer Durchlasskante bei 423 nm (vor Bestrahlung durch schnelle Elektronen und nachfolgendem Aushärten) addiert, wodurch die Endfarbe des Diamantenkristalls als intensive Phantasiepurpurrotfarbe bedingt ist.

### Beispiel 2:

Ein Kristall eines Naturdiamanten, dessen Masse 2,948 Karat beträgt und der den Verarmungstyp A enthält, wurde mit einer Konzentration verwendet, die das Aufzeichnen von Spektren der infraroten Absorbierung nicht ermöglicht. Davon wurde ein Muster mit einer Masse von 0,236 Karat abgesägt, aus dem zwei Planparallelplatten mit einer Stärke von 0,2 und 0,3 mm gewonnen wurden. Die Konzentration an Verarmungstypen A in den beiden Platten beträgt etwa 800 ppm. In den Spektren der infraroten Absorbierung wurde ein einziges Streifensystem mit dem intensivsten Streifen von 1282 cm⁻¹ verfolgt, der für Diamanten des Typs la kennzeichnend ist, die den Verarmungstyp A enthalten. Die Absorbierungskante lag im ultravioletten Spektrum bei 300 nm. Es fehlte die Absorbierung im sichtbaren Bereich. Dann wurden die beiden Platten durch einen hochenergetischen Elektronenstrom (3,0 MB, 10¹⁹cm⁻²) bestrahlt. Im Laufe der Bestrahlung haben die Platten eine vollkommen schwarze, undurchsichtige Farbe erworben.

Nach der Bestrahlung wurden die Platten in einer evakuierten Quarzampulle bei einer Temperatur von etwa 1100° C während 24 Stunden ausgeglüht. Der Aushärtungsvorgang hat die Durchsichtigkeit der beiden Platten wiederhergestellt, wobei er ihnen eine Phantasieviolettrotfarbe verliehen hat. In den Spektren der infraroten Absorbierung außer dem mit dem Verarmungstyp A verbundenen Streifensystem wurde die Absorbierung in einem Streifen von 1450 cm⁻¹ verfolgt, dessen Auftreten im Zusammenhang mit einem einzelnen Zwischengitter-stickstoffatom in Spektren betrachtet wurde, was auch für Kristalle des Kunstdiamanten im Werk von Malogolowetz, W. G., Erforschung von Beimischungs-zusammensetzung und wirklichem Aufbau der Kunstdiamanten mit Hilfe von spektroskopischen Verfahren, Autoreferat der Dissertation im Bereich physikalisch-mathematischer Wissenschaften, Kiew, IPM Akademie für Wissenschaften, USSR, 1979, S. 21, beschrieben wurde. Die Absorbierung in dem schmalen Streifen von 1346 cm⁻¹, die durch den Verarmungstyp C bedingt ist, wurde ebenfalls verfolgt. Das heißt, dass im Kristallgitter des Diamanten neben Zwischengitterstickstoffatome, auch isolierte Stickstoffatome in der Substitutionsposition (Verarmungstyp C) erschienen sind. Die Konzentration des Verarmungstyps C beträgt dabei etwa 5 ppm; im sichtbaren Spektrum ist ein intensives Absorbierungssystem von 640 nm erschienen, das von einer Herausbildung von N-V-Färbungszentren zeugt. Nach dem Anstreichen der beiden Platten in rot wurden die gleichen technologischen Prozeduren auch mit dem großen Muster (dem Diamanten mit einer Masse von 2,712 Karat) durchgeführt. Dieser Diamant veränderte seine Farbe ebenso von der ursprünglichen durchsichtigen Farbe zu einer intensiven Phantasieviolettrotfarbe.

Also kann das Verfahren zur Gewinnung von Diamanten mit einer Phantasierotfarbe gemäß der Erfindung Anwendung finden; diese Diamanten sind für die Erzeugung geschliffener Diamanten tauglich. Mithilfe dieses Verfahrens können alle Originaldiamanten des Typs la bearbeitet und veredelt werden, und zwar solche, die im ursprünglichen Zustand keine Stickstoffbeimischung vom Verarmungstyp C enthalten, die aber in beliebigen Konzentrationen eine Stickstoffbeimischung vom Verarmungstyp A und/oder B1 aufweisen.

## Patentansprüche

1. Verfahren zur Gewinnung von Diamanten mit einer Phantasierotfarbe mit standfesten Färbungszentren, die im Bereich von Wellenlängen von 400-640 nm absorbieren, durch Bestrahlung mit einem Elektronenstrom und Aushärten bei einer Temperatur von mindestens 1100° C im Vakuum,
**dadurch gekennzeichnet,**
**dass** Naturdiamanten des Typs la verwendet und im Kristallgitter dieser Naturdiamanten isolierte Stickstoffatome in der Substitutionsposition vom Verarmungstyp C gebildet werden, und zwar durch eine Hochtemperatur-Bearbeitung in einem Hochdruckgerät bei einer Temperatur von mehr als 2150° C und bei einem stabilisierten Druck von 6,0-7,0 Gpa, der vor der Bestrahlung durch einen hochenergetischen Elektronenstrom mit einer Dosis von 5x10¹⁵- 5x10¹⁸cm⁻² bei 2-4 MV unter Verwendung von Diamanten, die den Verarmungstyp A enthalten, oder durch einen hochenergetischen Elektronenstrom mit einer Dosis von mehr als 10¹⁹cm⁻² unter Verwendung von Naturdiamanten mit einem hohen Stickstoffgehalt ausgeübt wird, die mehr als 800 ppm Stickstoffbeimischung als Verarmungstyp A und B 1 enthalten.
